# EUROPÄISCHE PATENTSCHRIFT

(11) **EP 0 766 089 B1**
(45) Veröffentlichungstag und Bekanntmachung des Hinweises auf die Patenterteilung: **05.12.2001**
(21) Anmeldenummer: 96114486.2
(22) Anmeldetag: 10.09.1996
(51) Int. Cl.: G01P 15/08

(54) **Verfahren zur Herstellung eines mikroelektronischen, integrierten Sensors**
Method for manufacturing a microelectronic integrated sensor
Procédé de fabrication d'un microcapteur intégré

(30) Priorität: 28.09.1995 DE 19536228
(43) Veröffentlichungstag der Anmeldung: 02.04.1997
(73) Patentinhaber: Infineon Technologies AG, 81669 München (DE)
(72) Erfinder: Kolb, Stefan, Dipl.-Ing. (FH), 85716 Unterschleissheim (DE)
(74) Vertreter: Fischer, Volker, Dipl.-Ing.

(56) Entgegenhaltungen:
- DE-A- 4 332 843
- US-A- 4 882 933
- US-A- 5 241 864
- US-A- 5 258 097

## Beschreibung

Mikroelektronische integrierte Sensoren werden beispielsweise zur Messung von Beschleunigungen eingesetzt. Beispielsweise ist in dem US-Patent 4,882,933 ein Beschleunigungssensor mit einem Cantilever beschrieben, der den Bewegungsbereich des Cantilevers begrenzt. In dem US-Patent 5,258,097 ist ein Verfahren angegeben, mit dem eine freischwebende Struktur, die an dem Substrat verankert ist, hergestellt werden kann.

Der Cantilever dient dabei zusammen mit einer weiteren Fläche als Kapazität, wobei Kapazitätsänderungen als Meßgröße ausgewertet werden. Üblicherweise sind die bisher bekannten Cantilever über eine Feder während des gesamten Herstellungsvorgangs fest in dem Sensor verankert. Die Prozeßabläufe bei der Herstellung des Sensors führen jedoch zu Streß, insbesondere mechanischen Streß, in dem Cantilever. Bei einer nicht vollständigen Relaxierung der Federn kann sich der Cantilever dadurch verbiegen. Weiterhin können die in den Federn aufgenommenen Kräfte zu einem Fehlverhalten des Cantilevers während des Betriebs führen.

Aufgabe der vorliegenden Erfindung ist es, ein Verfahren zur Herstellung eines mikroelektronischen, integrierten Sensors anzugegeben, mit dem das Problem eines mechanischen Stresses in dem Cantilever behoben wird.

Diese Aufgabe wird mit dem Verfahren mit den Merkmalen des Anspruches 1 gelöst. Ausgestaltungen ergeben sich aus den abhängigen Ansprüchen.

Nach einem wesentlichen Gedanken der Erfindung ist der Cantilever an einem Auflager aufgelegt, sind seitliche und obere Bewegungsbegrenzungen vorhanden, die in der Weise von einem Rand des Cantilevers beabstandet sind, daß einerseits ausreichende Ausgleichsbewegungen des Cantilevers zur Vermeidung von mechanischem Streß möglich sind, und daß andererseits die Ausgleichsbewegungen nur im Bereich des Auflagers möglich sind.

Auf diese Weise wird ein vollständig und frei relaxierbarer Cantilever geschaffen, der auf dem Auflager, beispielsweise Lagerpunkten, aufgelegt ist, auf denen er sich im wesentlichen frei bewegen kann und seitlich und von oben so weit in seiner Bewegung begrenzt wird, daß ein Verschieben oder Abrutschen über die tragenden Lagerpunkte hinaus verhindert wird.

Das Auflager und die Bewegungsbegrenzung können günstigerweise auch als eine Einheit ausgebildet sein, wobei bevorzugt eine den Cantilever-Außenrand sacklochförmig umgebende Aufnahmeeinrichtung vorgesehen ist. Ebenso kann man hier auch von einer schlitzförmigen oder nutartigen Aufnahme des Cantilevers sprechen. Die Bewegungsbegrenzungen und das Auflager oder spezieller die Lagerpunkte sind bevorzugt im gesamten Umfangsbereich des Cantilevers vorgesehen. Ebenso können jedoch beide oder nur die Lagerpunkte oder nur die Bewegungsbegrenzungen punktförmig an einzelnen Stellen des Cantilevers angeordnet sein.

In einer bevorzugten Ausführungsform ist die Bewegungsbegrenzung in Form einer Stütze ausgebildet, die durch eine in dem Cantilever gebildete Ausnehmung geführt wird. Die Bewegungsbegrenzung greift in diesem Fall also nicht an dem Außenrand des Cantilevers, sondern an dem in der Ausnehmung gebildeten Rand des Cantilevers an.

Bei dem Verfahren zur Herstellung eines mikroelektronischen, integrierten Sensors mit einem in einem Hohlraum ausgebildeten Cantilever wird nach einem wesentlichen Gedanken der Erfindung auf einem Substrat ein erstes Oxid erzeugt, welches als Ausgangsbasis für die Erzeugung der Lagerpunkte dient, darauf eine zweite Oxidschicht abgeschieden, die eine höhere Ätzrate als die erste Oxidschicht besitzt, eine erste Polysiliziumschicht zur Cantileverbildung abgeschieden, dotiert und rekristallisiert, in der ersten Polysiliziumschicht ein Löcherarray strukturiert, welches zum Durchleiten der am Ende des Prozeßablaufs durchgeführten Oxidätzung dient, eine dritte Oxidschicht mit einer der zweiten Oxidschicht ähnlichen Ätzrate aufgebracht, wobei die zweite und die dritte Oxidschicht als Basis für die Erzeugung einer seitlichen Bewegungsbegrenzung dienen, eine weitere Materialschicht mit einer Ätzrate aufgebracht, die niedriger ist als die Ätzrate der zweiten und dritten Oxidschichten, eine zweite Polysiliziumschicht zur Bildung eines Deckels aufgebracht, in der zweiten Polysiliziumschicht ein Löcherarray strukturiert und durch dieses Löcherarray eine isotrope Ätzung der zuletzt aufgebrachten Materialschicht, sowie der dritten, zweiten und ersten Oxidschicht zur Bildung des Hohlraums durchgeführt.

Mit diesem Verfahren wird ein Cantilever in einem Hohlraum innerhalb eines Sensors ausgebildet, der auf einem aus einer ersten Oxidschicht ausgebildeten Auflagepunkt, von aus der zweiten und dritten Oxidschicht gebildeten seitlichen Bewegungsbegrenzungen und einer aus der oberen Materialschicht gebildeten oberen Bewegungsbegrenzung in einem vorgegebenen Bereich beweglich gehalten wird.

Bei dem Verfahren wird bevorzugt das erste Oxid durch eine LOCOS-Technik, also als thermisches Oxid, gebildet. Die zweite und dritte Oxidschicht bestehen vorteilhafterweise aus einem abgeschiedenen Oxid, welches beispielsweise aus TEOS gebildet werden kann. Die darauf aufgebrachte Materialschicht besteht in einer bevorzugten Ausführungsform aus Borphosphorsilikatglas (BPSG).

Während der Oxidätzung zur Bildung des Hohlraums besteht die Möglichkeit, daß der aus der ersten Polysiliziumschicht oder einer Siliziumschicht gebildete Cantilever sich am Auflager oder einer anderen Fläche im Zusammenwirken mit der Ätzflüssigkeit festsaugt. Aus diesem Grund ist es vorteilhaft, während des Herstellungsprozesses Lackstützen vorzusehen, die auf einfache Weise durch eine zweistufige Erzeugung des Löcherarrays in der zweiten Polysiliziumschicht gebildet werden können. Dabei werden mit einer ersten Fototechnik einige Löcher strukturiert, in denen dann Lackstützen ausgebildet werden. In diesen Löchern wird zunächst eine anisotrope Ätzung mit einer teilweise isotropen Komponente durchgeführt. Zur Erzeugung der übrigen Löcher des Löcherarrays in der zweiten Polysiliziumschicht wird erneut eine Lackmaske aufgebracht, die lediglich die jetzt zu erzeugenden Löcher frei läßt und daher auch im Bereich der zuerst erzeugten Löcher aufgebracht wird. Dabei füllen sich die vorher geätzten Hohlräume mit Lack und untergreifen aufgrund der isotropen Komponente der ersten Ätzung auch die erste Polysiliziumschicht. Für die Ausbildung dieser Lackstützen ist es notwendig, daß die dafür verwendeten Löcher im Löcherarray der ersten Polysiliziumschicht im wesentlichen mit den Löchern der zweiten Polysiliziumschicht übereinstimmen.

Nachfolgend wird die Erfindung anhand eines in der Zeichnung dargestellten Ausführungsbeispiels näher erläutert. Im einzelnen zeigen die schematischen Darstellungen in:
- Figur 1: einen schematischen Querschnitt durch einen mikroelektronischen Sensor mit Cantilever während des Herstellungsverfahrens;
- Figur 2: einen mikroelektronischen Sensor mit Cantilever gegen Ende des Herstellungsverfahrens; und
- Figur 3: eine teilgeschnittene Draufsicht auf einen mikroelektronischen Sensor.

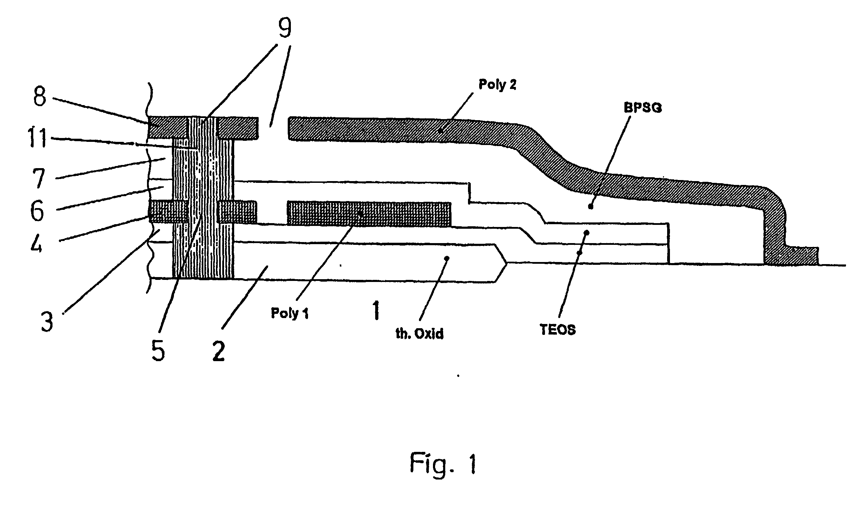

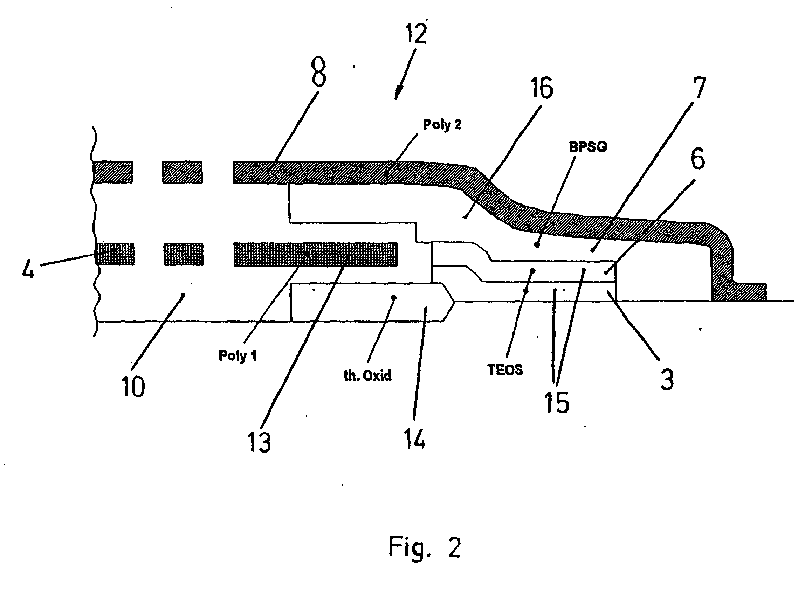

In Figur 1 sind die in den verschiedenen Verfahrensschritten aufgebrachten und strukturierten Materialschichten dargestellt. Dabei wird ausgehend von einem Substrat 1 mit einer LOCOS-Technik ein thermisches Oxid erzeugt. Dieses wird mit einer ersten Fototechnik strukturiert. Darauf wird durch Aufbringen einer TEOS-Schicht (Tetraäthyloxysilikat) ein Oxid zur Bildung einer zweiten Oxidschicht 3 abgeschieden. Dieses wird mit einer zweiten Fototechnik strukturiert. Dabei ist zu beachten, daß diese zweite Oxidschicht aus abgeschiedenem Oxid eine höhere Ätzrate aufweist als die darunter liegende erste Oxidschicht 2 aus thermischem Oxid. Darauf wird eine erste Polysiliziumschicht 4 abgeschieden, die zur Cantileverbildung dient. Diese Polysiliziumschicht 4 wird dann dotiert und mit Hilfe einer Hochtemperaturbehandlung rekristallisiert und dabei eine Dotierstoffaktivierung durchgeführt. Mit Hilfe einer dritten Fototechnik wird diese Polysiliziumschicht 4 strukturiert, wobei zum einen, genau wie bei den anderen Schichten auch, eine Definition und Strukturierung der äußeren Abmessungen stattfindet, und zum anderen in der Polysiliziumschicht ein Löcherarray 5 erzeugt wird. Die dabei erzeugten Löcher dienen später zum Durchtreten der Ätzflüssigkeit zur Oxidätzung in die unter der Polysiliziumschicht 4 liegenden Oxidschichten 2 und 3. Im nächsten Schritt wird wiederum eine TEOS-Beschichtung zur Oxidabscheidung aufgebracht. Diese dritte Oxidschicht 6 wird mit einer vierten Fototechnik zur Festlegung ihrer Außenabmessungen strukturiert. Das Oxid füllt ebenfalls die voher in der ersten Polysiliziumschicht erzeugten Löcher 5 aus. Die zweite Oxidschicht 3 und die dritte Oxidschicht 6 bestehen aus dem gleichen Material und weisen daher beide die gleiche Ätzrate auf, die höher ist als die der ersten Oxidschicht 1. Im nächsten Schritt wird eine Materialschicht 7 aufgebracht, die eine niedrigere Ätzrate aufweist als die zweite und dritte Oxidschicht. Dafür wird hier Borphosphorsilikatglas verwendet. Anschließend wird ein Verdichtungsschritt durchgeführt und damit gleichzeitig ein Planarisierungseffekt erreicht. Auf die BPSG-Schicht 7 wird eine zweite Polysiliziumschicht 8 aufgebracht, die zur Abdeckung des Sensors dient. Diese Polysiliziumschicht 8 wird dotiert, ebenfalls mit einem Hochtemperaturverfahren rekristallisiert und die vorhandenen Dotierstoffe aktiviert. Bei der folgenden Fototechnik zur Strukturierung der Polysiliziumschicht 8 werden zum einen die äußeren Abmessungen des Sensors festgelegt und zum anderen bereits einige Löcher des Löcherarrays 9 erzeugt, in denen Lackstützen angeordnet werden sollen. Das Polysilizium wird an den durch die Maske freigegebenen Stellen geätzt, die im wesentlichen mit Löchern in der darunter liegenden ersten Polysiliziumschicht 4 übereinstimmen. Mit einer trockenen, anisotropen Oxidätzung mit einer isotropen Komponente wird in dem Sensor ein bis auf das Substrat 1 herunterreichendes Loch erzeugt, das im wesentlichen senkrecht ist und die Polysiliziumschichten 4 und 8 im Bereich des Ätzloches untergreift. Mit einer zweiten Fototechnik werden die übrigen Löcher des Löcherarrays 9 in der zweiten Polysiliziumschicht 8 erzeugt. Dafür wird zunächst eine entsprechende Lackmaske aufgebracht, die auch die mit der vorausgehenden Fototechnik erzeugten Löcher der zweiten Polysiliziumschicht 8 abdeckt. Dabei werden die im vorhergehenden Ätzschritt erzeugten Löcher mit Lack gefüllt, so daß sich Lackstützen 11 innerhalb des Sensors ausbilden. Durch die übrigen offenen Löcher in der zweiten Polysiliziumschicht 8 wird dann eine nasse, isotrope Oxidätzung vorgenommen, die aufgrund der unterschiedlichen Ätzraten der Oxidschichten 2, 3 und 6 und der darüber liegenden BPSG-Schicht 7 einen Hohlraum 10 erzeugt, der in Figur 2 dargestellt ist. Durch die Lackstütze 11 wird die den Cantilever bildende erste Polysiliziumschicht 4 über dem das Auflager bildenden thermischen Oxid 2 gehalten und ein Festsaugen während des Ätzprozesses verhindert.

Anschließend wird die Lackstütze 11 entfernt. Dieser Verfahrensstand ist in Figur 2 dargestellt. In den nächsten Schritten wird das Löcherarray in der zweiten Polysiliziumschicht ebenso wie Teile der BPSG-Schicht 7 wieder verschlossen. Im Bereich des Pfeils 12 wird mit einer Fototechnik ein Kontaktloch strukturiert und anschließend die Kontaktlochätzung durchgeführt. Durch dieses Kontaktloch wird eine Metallisierung zur Kontaktierung des Cantilevers durchgeführt. Mit diesem Verfahren ist also ein Sensor geschaffen worden, dessen Cantilever 13 auf einem Lagerpunkt 14 aufliegt und von diesem getragen wird. Ein seitliches Verrutschen des Cantilevers 13 wird durch seitliche Bewegungsbegrenzungen 15, die auf mehreren Seiten des Cantilevers 13 angeordnet sein müssen, verhindert. Außerdem sind obere Bewegungsbegrenzungen 16 zur Verhinderung eines Verkantens vorgesehen. Der Sensor kann jetzt bestimmungsgemäß durch die sich verändernden Kapazitäten zwischen dem Cantilever und der Polysiliziumschicht 8 einerseits und dem Cantilever und dem Substrat 1 andererseits arbeiten. Da der Lagerpunkt 14 und die seitlichen Bewegungsbegrenzungen 15 aus Oxid und die obere Bewegungsbegrenzung 16 aus BPSG besteht, wird der Cantilever elektrisch isoliert vom Substrat 1 und der zweiten Polysiliziumschicht 8 gelagert.

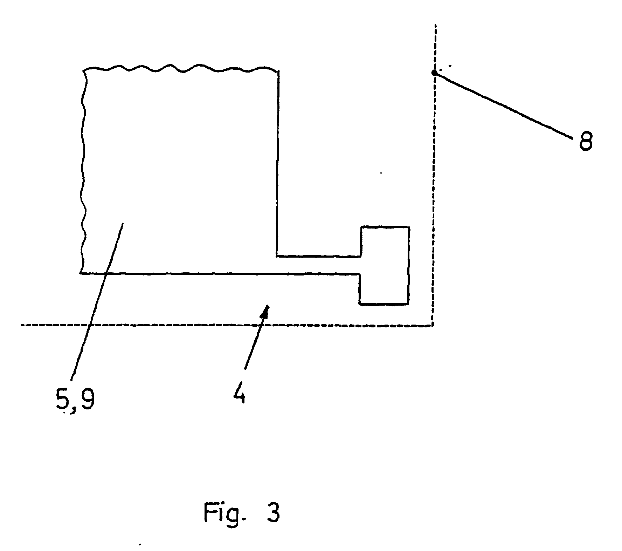

In Figur 3 ist eine Draufsicht auf den Sensor dargestellt, wobei die äußere gestrichelte Linie die äußeren Abmessungen anzeigt, die durch die zweite Polysiliziumschicht 8 bestimmt werden. Diese wirkt als Deckel und liegt oberhalb des darunter liegenden Cantilevers. Die durchgehende Linie zeigt die Abmessungen der ersten Polysiliziumschicht 4, in deren zentralen Bereich das Löcherarray 5 ausgebildet ist. Genau darüber befindet sich auch das Löcherarray 9 der zweiten Polysiliziumschicht 8. Die Auflagepunkte und die Bewegungsbegrenzungen sind in dem rechts unten angeordneten Fortsatz des Cantilevers angeordnet, können jedoch auch direkt am Rand angeordnet sein.

Bei einigen Anwendungen ist die obere Abdeckung nicht nötig, so daß in diesen Fällen der Cantilever unmittelbar von außen zugänglich ist und lediglich eine Art Platte über einem Hohlraum darstellt. Solche Ausführungsformen können beispielsweise als Drucksensor eingesetzt werden.

## Patentansprüche

1. Verfahren zur Herstellung eines mikroelektronischen, integrierten Sensors, bei dem
auf einem Substrat (1) eine erste Oxidschicht (2) erzeugt wird, welche als Ausgangsbasis für die Erzeugung eines Auflagers vorgesehen ist,
darauf eine zweite Oxidschicht (3) abgeschieden wird, die eine höhere Ätzrate als die erste Oxidschicht besitzt,
eine erste Polysiliziumschicht (4) abgeschieden, dotiert und rekristallisiert wird,
in der ersten Polysiliziumschicht ein Löcherarray (5) zur späteren isotropen Ätzung der ersten und zweiten Oxidschichten (2, 3) strukturiert wird,
eine dritte Oxidschicht (6) aufgebracht wird, deren Ätzrate ähnlich der Ätzrate der zweiten Oxidschicht (3) ist und die zusammen mit der zweiten Oxidschicht (3) zur Bildung einer in Bezug auf die Polysiliziumschicht (4) seitlichen Bewegungsbegrenzung (15) vorgesehen ist,
eine Materialschicht (7) mit einer niedrigeren Ätzrate als die der zweiten und dritten Oxidschicht (3, 6) zur Bildung einer auf der der ersten Oxidschicht gegenüberliegenden Seite der Polysiliziumschicht angeordneten oberen Bewegungsbegrenzung (16) aufgebracht wird,
eine zweite Polysiliziumschicht (8) zur Bildung eines Deckels aufgebracht wird,
in der zweiten Polysiliziumschicht (8) ein Löcherarray zum Durchlaß eines Ätzmittels strukturiert wird, und
eine isotrope Oxidätzung durchgeführt wird zur Bildung eines Hohlraums (10) und zur Ausbildung eines vollständig und frei relaxierbaren Cantilevers (13) in der ersten Polysiliziumschicht, der auf einem durch die erste Oxidschicht hergestellten Auflager aufgelegt ist und von aus der zweiten und dritten Oxidschicht gebildeten seitlichen Bewegungsbegrenzungen und einer aus der Materialschicht gebildeten oberen Bewegungsbegrenzung in einem vorgegebenen Bereich beweglich gehalten wird.

2. Verfahren nach Anspruch 1,
**dadurch gekennzeichnet,**
**daß** zur Bildung der ersten Oxidschicht mit einer LOCOS-Technik ein thermisches Oxid erzeugt wird,
die zweite und dritte Oxidschicht (3, 6) durch TEOS-Abscheidung erzeugt werden und als weiteres Material darauf eine Borphosporsilikatglas-Schicht abgeschieden wird.

3. Verfahren nach Anspruch 1 oder 2,
**dadurch gekennzeichnet,**
**daß** die Herstellung des Löcherarrays (9) in der zweiten Polysiliziumschicht (8) in zwei Schritten durchgeführt wird, wobei nach Ätzung der ersten Löcher eine anisotrope Oxidätzung mit isotroper Komponente durchgeführt wird, und die dabei erzeugten Hohlräume bei der Lackaufbringung zur Strukturierung der zweiten Löcher unter Bildung von Lackstützen (11) mit Lack gefüllt werden.

## Claims

1. Method for producing a microelectronic integrated sensor, in which
a first oxide layer (2) is produced on a substrate (1), which layer is provided as an initial basis for the production of a bearing,
a second oxide layer (3) is deposited thereon, the said second oxide layer having a higher etching rate than the first oxide layer,
a first polysilicon layer (4) is deposited, doped and recrystallized,
a hole array (5) is patterned in the first polysilicon layer for the purpose of later isotropic etching of the first and second oxide layers (2, 3),
a third oxide layer (6) is applied, whose etching rate is similar to the etching rate of the second oxide layer (3) and which is provided together with the second oxide layer (3) for the purpose of forming a lateral movement limitation (15) with regard to the polysilicon layer (4),
a material layer (7) having a lower etching rate than that of the second and third oxide layers (3, 6) is applied for the purpose of forming an upper movement limitation (16) arranged on that side of the polysilicon layer which is opposite to the first oxide layer,
a second polysilicon layer (8) is applied for the purpose of forming a cover,
a hole array is patterned in the second polysilicon layer (8) for the passage of an etchant, and
isotropic oxide etching is carried out for the purpose of forming a cavity (10) and for the purpose of forming a completely and freely relaxable cantilever (13) in the first polysilicon layer, which cantilever is placed on a bearing produced by the first oxide layer and is held such that it is movable in a predetermined region by lateral movement limitations formed from the second and third oxide layers and an upper movement limitation formed from the material layer.

2. Method according to Claim 1,
**characterized**
**in that**, in order to form the first oxide layer, using a LOCOS technique, a thermal oxide is produced,
the second and third oxide layers (3, 6) are produced by TEOS deposition and a borophosphorus silicate glass layer is deposited as further material thereon.

3. Method according to Claim 1 or 2,
**characterized**
**in that** the production of the hole array (9) in the second polysilicon layer (8) is carried out in two steps, in which case, after the etching of the first holes, anisotropic oxide etching with an isotropic component is carried out, and the cavities produced in the process are filled with resist during the application of resist for the purpose of patterning the second holes with the formation of resist supports (11).

## Revendications

1. Procédé de fabrication d'un capteur micro-électronique intégré, dans lequel
on produit sur un substrat (1) une première couche (2) d'oxyde qui est prévue comme base de départ pour la production d'un support,
on y dépose une deuxième couche (3) d'oxyde qui a une vitesse d'attaque chimique plus grande que la première couche d'oxyde,
on dépose, dope et recristallise une première couche (4) de polysilicium,
dans la première couche de polysilicium, on structure un réseau (5) de trous pour l'attaque chimique isotrope ultérieure des première et deuxième couches (2, 3) d'oxyde,
on dépose une troisième couche (6) d'oxyde dont la vitesse d'attaque chimique est analogue à la vitesse d'attaque de la deuxième couche (3) d'oxyde et qui est prévue pour former ensemble avec la deuxième couche (3) d'oxyde une limitation (15) latérale de mouvement par rapport à la couche (4) de polysilicium,
on dépose une couche (7) de matière ayant une vitesse d'attaque chimique plus petite que celle de la deuxième et de la troisième couches (3, 6) d'oxyde pour former une limitation (16) supérieure de mouvement disposée sur la face de la couche de polysilicium opposée à la première couche d'oxyde,
on dépose une deuxième couche (8) de polysilicium pour former un couvercle,
on structure dans la deuxième couche (8) de polysilicium un réseau de trous pour le passage d'un agent d'attaque chimique et
on effectue une attaque chimique isotrope de l'oxyde pour former une cavité (10) et pour former un porte-à-faux (13) pouvant être relaxé entièrement et librement dans la première couche de polysilicium, qui est appliqué sur un support produit par la première couche d'oxyde et qui est maintenu mobile dans une région prescrite par des limitations latérales de mouvement formées dans la deuxième et troisième couches d'oxyde et par une limitation supérieure de mouvement formée dans la couche de matériau.

2. Procédé suivant la revendication 1,
**caractérisé**
**en ce que** l'on produit pour former la première couche d'oxyde un oxyde thermique par une technique LOCOS,
on produit la deuxième et la troisième couches (3, 6) d'oxyde par un dépôt TEOS et on y dépose comme autre matière une couche de verre au borophosphosilicate.

3. Procédé suivant la revendication 1 ou 2,
**caractérisé**
**en ce que** l'on effectue la production de réseau (9) de trous dans la deuxième couche (8) de polysilicium en deux stades en effectuant après l'attaque chimique des premiers trous une attaque chimique d'oxyde anisotrope par des constituants isotropes et en remplissant les cavités ainsi produites de vernis lors du dépôt de vernis pour la structuration des deuxièmes trous avec formation d'appui (11) en vernis.
